# EUROPEAN PATENT SPECIFICATION

(11) **EP 0 442 637 B1**
(45) Date of publication and mention of the grant of the patent: **22.04.1998**
(21) Application number: 91300811.6
(22) Date of filing: 01.02.1991
(51) Int. Cl.: H03F 3/19

(54) **Circuit arrangement for connecting RF amplifier and supply voltage filter**
Schaltungsanordnung für die Verbindung von einem Hochfrequenzverstärker mit einem Versorgungsspannungsfilter
Montage de circuit pour lier un amplificateur haute fréquence et un filtre de tension d'alimentation

(30) Priority: 16.02.1990 FI 900803
(43) Date of publication of application: 21.08.1991
(73) Proprietor: NOKIA MOBILE PHONES LTD., 24101 Salo (FI)
(72) Inventor: Nyqvist, Jouni, SF-25130 Muurla (FI); Huusko, Risto, SF-24100 Salo (FI)
(74) Representative: Johansson, Folke Anders

(56) References cited:
- EP-A- 0 160 223
- DE-A- 2 712 680
- US-A- 3 422 365
- US-A- 3 671 884

## Description

The invention relates to a circuit in which the RF amplifier circuit also serves as a filter for the supply voltage produced from the supply voltage of the amplifier.

Usually a high frequency amplifier, primarily a radio frequency amplifier, has been implemented using a common emitter transistor i.e. the radio frequency signal to be amplified is applied to the transistor base and the amplified output signal is obtained from the collector circuit. The emitter of the transistor has in general been connected directly to the ground of the circuit. As is known in the art, the operating point of the transistor is set from the supply voltage using resistors, and the DC separation of the input and the output is performed by means of capacitors. The collector current is determined with base current, which in turn is determined by the resistance division which sets the operating point. Because of the temperature dependence of the base-emitter voltage, the temperature compensation of the bias voltage of the transistor is made, for instance, by using a diode or resistive counteraction obtained through the collector line. If the emitter has been connected to the ground of the circuit through a resistor and the emitter voltage is high, the junction voltage of the base emitter will not essentially change the collector current, whereas, on the other hand, power losses take place in the resistor connected to the emitter, through which resistor the emitter current approaching the magnitude of collector current runs.

The filtering of the supply voltage may be arranged in a number of ways as is known in the art. One of the basic ways is to use a simple RC filter. For such a filter to be appropriate in filtering a supply voltage line, a high ohm resistor and a high capacitance capacitor should be used.

Hereby, a drawback is the great voltage loss produced by the loading current passing through the resistor and also the power loss produced herewith. A very small resistor cannot be used because the filtering effect will be reduced. Further, a more profitable way is to use an emitter follower circuit in which the supply voltage to be filtered is applied to the collector of the transistor the base of which has through a resistor been connected to the supply voltage to be filtered, and to the ground through a capacitor. The filtered supply voltage is received from the transistor emitter. In the circuit the main current travels through the collector, and the base current, that is, the current passing through the resistor, has been reduced to a β (beta) part, compared with the current passing through the simple RC filter whereby a high RC input can be used.

It has been a practice to date that the above described high frequency amplifier has been a separate circuit of its own and that the filtered supply voltage needed by other circuits has been produced using a separate circuit similar to the one described above. This has naturally added to the number of components required.

The present invention introduces a circuit arrangement with which the shortcomings of separate amplifier and filter circuits can be eliminated and with which the current passing through the amplifier transistor may be used for two purposes: first, in conjunction with amplifying the input signal of the amplifier, and second, as the current for the supply voltage to be produced.

German Patent Application DE-A-27 12 680 discloses a multi-stage transistor amplifier having an ac voltage supply, which has at least two amplification stages coupled together. The sum of the currents of the coupled together-stages is used as the supply for a further amplification stage.

European Patent Application EP-A-O 160 223 discloses a high voltage, high frequency amplifier employing transistors. The amplifier provides parallel ac signal amplification paths through each transistor and a single dc power path through the transistor in series.

According to the present invention there is provided a circuit arrangement for combining a high frequency amplifier circuit, supplied by a first supply voltage input and including a common emitter transistor with ancillary components, and a filter circuit for a second supply voltage produced from the first supply voltage, characterised in that
the filter is an active filter obtained by having filtering components at the base current flow route of said common emitter transistor,
a further component is provided between the filtering components and the base of said common emitter transistor,
the second supply voltage is output from the emitter of said transistor,
the emitter of said transistor is connected to the ground of the circuit arrangement through a first capacitor, and
said transistor serves as an emitter follower in said active filter.

Therefore, the basic circuit of the invention comprises a common emitter amplifier including a transistor with ancillary components. Said amplifier circuit acts as a filter for the supply voltage which is taken from the emitter of the transistor. The transistor acts thus in the manner of filter circuits known in the art in the form of emitter follower in the filter in addition to RF amplifier activity. With said circuit, two separate circuits have been contacted into one circuit provided with two operations.

The circuit arrangement of the invention is described below more concretely, referring to the accompanying drawings in which:
Figure 1 presents a circuit according a preferable embodiment of the invention,
Figure 2 shows the attenuation measured of the signal between the supply voltages V_{cc} and V_{cc} out, and
Figure 3 shows the gain curve between RF/in and RF/out.

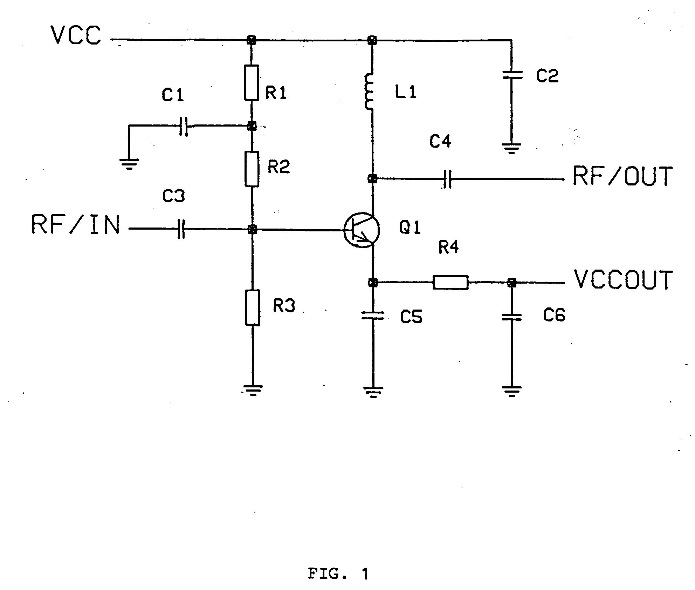

Figure 1 presents a circuit arrangement of the invention. The RF amplifier comprises a transistor Q1, resistors R1, R2 and R3, capacitors C1, C2, C3, C4, C5, and a coil L1. The filtering circuit of the supply voltage V_{cc}out comprises, excluding the DC separation capacitors C3 and C4 of the RF signals, all components of the RF amplifier circuit, and in addition, the resistor R4 and the capacitor C6.

The amplifier part operates as follows: the voltage dividing resistors R1, R2 and R3 determine the bias voltage of the base of the transistor Q1, and the collector current is determined by the load connected to the voltage V_{cc}out. Said loading current is expected to be as steady as possible since when approaching the collector current of the transistor, its magnitude affects the gain of the transistor. An appropriate loading may be, for instance, another amplifier, an IC circuit, or equivalent. The emitter capacitor C5 grounds the emitter at the operational range of RF amplifier, and the coil L1 provides the impedance matching of the output RFout for the present frequency. The capacitors C3 and C4 are provided for the DC separation of the RF signals, and the C1 is used as a filter for stabilizing the bias voltage. The present circuit operates in the manner of a common emitter amplifier.

As to the filter circuit of the supply voltage V_{cc}out, it operates as follows. As regards the voltage V_{cc}out, the transistor Q1 serves as the emitter follower, and its bias-voltage is determined as already described above, at the resistor division R1, R2, R3. The voltage obtained from the emitter of the current buffer Q1 is conducted through the resistor R4 to be the load voltage V_{cc}out. Said voltage is naturally expected to be so high that it suffices for the circuit serving as the load. The filtering of the supply voltage V_{cc}out is performed in circuits R1-C1 and C5-R4-C6.

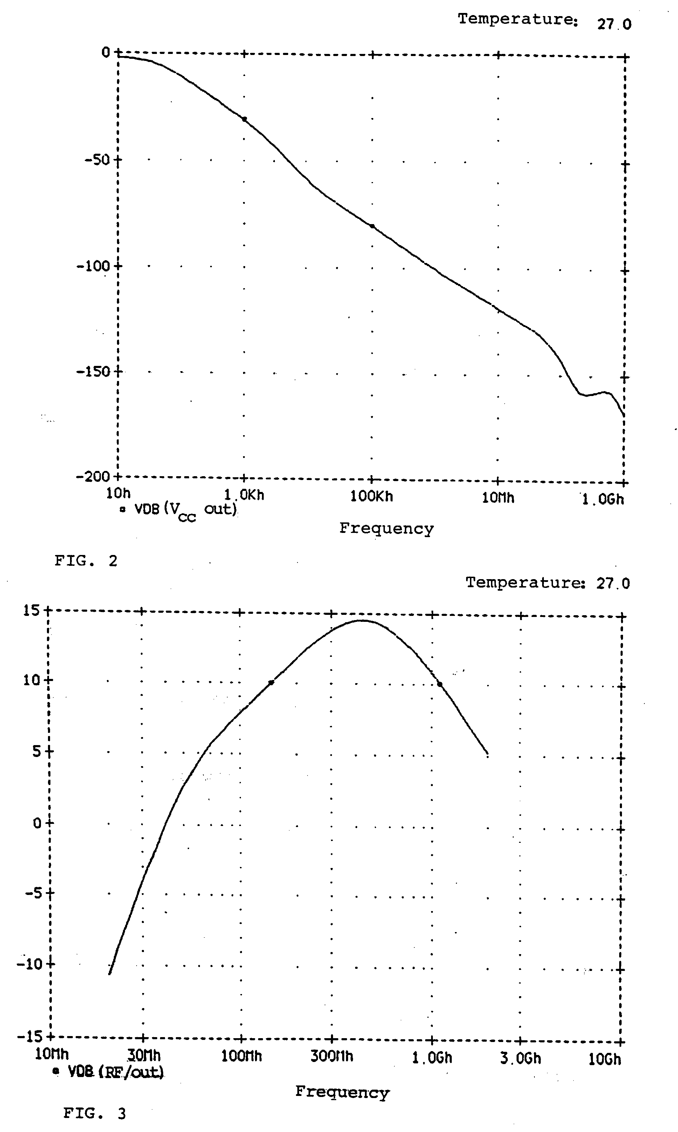

Fig. 2 shows a simulation of the attenuation of a signal between the supply voltages V_{cc} and V_{cc}out. On the horizontal axis, the frequency is 10 Hz to 1G Hz and on the vertical axis, the attenuation is 0 to 200 dB. In the simulated arrangement thereof a 1 kHz signal fed to V_{cc}, when viewed from the V_{cc}out output, attenuated 30 dB, and a 100 kHz signal over 80 dB. As regards the filtering of the supply voltage, this attenuation is sufficient. The attenuation is, of course, dependent on the component values used, but this simulation informs, however, of the order of magnitude of attenuation.

In the simulation of Fig. 3 is presented a typical gain curve between RFin and RFout. In the range 150 MHz to 1 GHz, the gain is over 10 dB. Even this value is actually dependent on the component values used.

The arrangement of the invention in which the filtering of the voltage of the amplifier connection produced from the supply voltage and the amplifier itself constitute a combined circuit saves both components and power in comparison with the separate arrangements known. in the art because the supply voltage can be utilized efficiently with the described double connection. Remaining within the sphere of the basic construction of the claim, the practical circuit realization can be implemented in a plurality of ways. Thus, the input matching, the output matching and the biasing of the. transistor are implemented to meet the requirements in each instance. The filter section may also comprise a plurality of filtering blocks to be in conformance with the requisite filtering requirements. All of this is obvious to a person skilled in the art and feasible to be implemented within the scope of protection of the claims.

## Claims

1. A circuit arrangement for combining a high frequency amplifier circuit, supplied by a first supply voltage (V_{cc}) input and including a common emitter transistor (Q1) with ancillary components, and a filter circuit for a second supply voltage (V_{cc}out) produced from the first supply voltage (V_{cc}), characterised in that
the filter is an active filter obtained by having filtering components (R1, C1) at the base current flow route of said common emitter transistor (Q1),
a further component (R2) is provided between the filtering components (R1, C1) and the base of said common emitter transistor (Q1),
the second supply voltage (V_{cc}out) is output from the emitter of said transistor (Q1),
the emitter of said transistor (Q1) is connected to the ground of the circuit arrangement through a first capacitor (C5), and
said transistor (Q1) serves as an emitter follower in said active filter.

2. A circuit arrangement according to claim 1, further comprising one or more filter stages (R4, C6), connected after the high frequency amplifier circuit, for further filtering the second supply voltage (V_{cc}out).

3. A circuit arrangement according to claim 1 characterised in that said further component is a resistive element (R2).

4. A circuit arrangement according to any of claims claim 1 to 3, wherein the second supply voltage (V_{cc}out) is for applying voltage to a load.

5. A circuit arrangement according to claim 4, wherein the load comprises an integrated circuit.

6. A circuit arrangement according to claim 4 or 5, wherein the load comprises a further amplifier.

## Patentansprüche

1. Schaltungsanordnung zur Kombination einer an einer ersten Eingangsversorgungsspannung (Vcc) anliegenden und einen Emitterschaltungs-Transistor (Q1) mit Zusatzkomponenten enthaltenden Hochfrequenzverstärkerschaltung, mit einer Filterschaltung für eine aus der ersten Versorgungsspannung (Vcc) erzeugte zweite Versorgungsspannung (V_{cc}aus), **dadurch gekennzeichnet**, daß
das Filter ein aktives Filter ist, das aus in Basisstromflußrichtung des Emitterschaltungs-Transistors (Q1) vorhandenen Filterkomponenten (R1, C1) gebildet ist;
zwischen den Filterkomponenten (R1, C1) und der Basis des Emitterschaltungs-Transistors (Q1) eine weitere Komponente (R2) angeordnet ist;
die zweite Versorgungsspannung (V_{ccaus}) über den Emitter des Transistors (Q1) ausgegeben wird;
der Emitter des Transistors (Q1) über einen ersten Kondensator (C5) mit der Masse der Schaltungsanordnung verbunden ist, und
der Transistor (Q1) in dem aktiven Filter als Emitterfolger betrieben wird.

2. Schaltungsanordnung nach Anspruch 1, mit einer oder mehreren nach der Hochfrequenzverstärkerschaltung verbundenen Filterstufen (R4, C6), um die zweite Versorgungsspannung (V_{cc}aus) zu filtern.

3. Schaltungsanordnung nach Anspruch 1, **dadurch gekennzeichnet**, daß die weitere Komponente ein ohmsches Element (R2) ist.

4. Schaltungsanordnung nach irgendeinem der Ansprüche 1 bis 3, bei dem die zweite Versorgungsspannung (V_{cc}aus) zur Spannungslieferung an eine Last dient.

5. Schaltungsanordnung nach Anspruch 4, bei der die Last eine integrierte Schaltung enthält.

6. Schaltungsanordnung nach Anspruch 4 oder 5, bei der die Last einen weiteren Verstärker enthält.

## Revendications

1. Agencement de circuit destiné à combiner un circuit d'amplificateur à haute fréquence, alimenté par une première entrée de tension d'alimentation (V_{CC}) et comprenant un transistor à montage à émetteur commun (Q1) et des composants accessoires, et un circuit de filtrage pour une seconde tension d'alimentation (V_{CC} de sortie) produite à partir de la première tension d'alimentation (V_{CC}), caractérisé en ce que
le filtre est un filtre actif obtenu en disposant des composants de filtrage (R1, C1) au niveau du cheminement de la circulation du courant dudit transistor à montage à émetteur commun (Q1),
un autre composant (R2) est prévu entre les composants de filtrage (R1, C1) et la base dudit transistor à montage à émetteur commun (Q1),
la seconde tension d'alimentation (V_{CC} de sortie) est sortie depuis l'émetteur dudit transistor (Q1),
l'émetteur dudit transistor (Q1) est relié à la masse de l'agencement de circuit par l'intermédiaire d'un premier condensateur (C5), et
ledit transistor (Q1) sert de montage émetteur-suiveur dans ledit filtre actif.

2. Agencement de circuit selon la revendication 1, comprenant en outre un ou plusieurs étages de filtres (R4, C6) reliés après le circuit d'amplificateur à haute fréquence, afin de filtrer davantage la seconde tension d'alimentation (V_{CC} de sortie).

3. Agencement de circuit selon la revendication 1, caractérisé en ce que ledit autre composant est un élément résistif (R2).

4. Agencement de circuit selon l'une quelconque des revendications 1 à 3, dans lequel la seconde tension d'alimentation (V_{CC} de sortie) est destinée à appliquer une tension à une charge.

5. Agencement de circuit selon la revendication 4, dans lequel la charge comprend un circuit intégré.

6. agencement de circuit selon la revendication 4 ou 5, dans lequel la charge comprend un autre amplificateur.
